Europäisches Patentamt

European Patent Office

Office européen des brevets

(19)

(11) Veröffentlichungsnummer : **0 187 402**
**B1**

# (12) EUROPÄISCHE PATENTSCHRIFT

(45) Veröffentlichungstag der Patentschrift :
**19.10.88**

(21) Anmeldenummer : **85201935.5**

(22) Anmeldetag : **22.11.85**

(51) Int. Cl.⁴ : **H 01 J 9/04, C 30 B 25/02,
C 23 C 16/14**

(54) Verfahren zur Herstellung von (111)-vorzugsorientiertem Wolfram.

(30) Priorität : **19.12.84 DE 3446334**

(43) Veröffentlichungstag der Anmeldung :
**16.07.86 Patentblatt 86/29**

(45) Bekanntmachung des Hinweises auf die Patenterteilung : **19.10.88 Patentblatt 88/42**

(84) Benannte Vertragsstaaten :
**BE DE FR GB NL**

(56) Entgegenhaltungen :
**EP-A- 0 081 270
EP-A- 0 087 826**

(73) Patentinhaber : **Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
BE FR GB NL**

(72) Erfinder : **Gärtner, Georg, Dr.
Goethestrasse 11
D-5100 Aachen (DE)**
Erfinder : **Janiel, Peter
Menzelstrasse 3
D-5102 Würselen (DE)**

(74) Vertreter : **Piegler, Harald, Dipl.-Chem. et al
Philips Patentverwaltung GmbH Wendenstrasse 35
Postfach 10 51 49
D-2000 Hamburg 1 (DE)**

**Beschreibung**

Die Erfindung betrifft ein Verfahren zur Herstellung von <111>-vorzugsorientiertem Wolfram durch reaktive Abscheidung aus einer Wolframhexafluorid und Wasserstoff enthaltenden Gasphase bei einem Gesamtdruck von 10 bis 100 hPa auf einem Substrat (Niederdruck-CVD-Verfahren).

Ein derartiges Verfahren ist aus der EP-A-0 087 826 bekannt. Darin ist ein Verfahren zur Herstellung einer thermionischen Kathode beschrieben, bei dem u.a. auch Simultan- und Alternativ-CVD-Verfahren zur Herstellung von dotierten Wolframschichten bzw. von Schichtenfolgen aus Wolfram und anderen Substanzen angewendet werden. In dieser Offenlegungsschrift ist dargelegt, daß eine polykristalline <111>-vorzugsorientierte Wolfram-Deckschicht eine notwendige Bedingung zur Erzielung einer maximalen Elektronenemissionsstromdichte bei thorierten Wolfram-Kathoden ist.

Die Abscheidung von <111>-vorzugsorientierten Wolframschichten erfolgt gemäß der EP-A-0 087 826 durch Einstellung der CVD-Parameter. Die Substrattemperatur beträgt z. B. etwa 500 °C, der Druck im Reaktor 10 bis 100 hPa, vorzugsweise 40 hPa. Die $WF_6$-Durchflußrate beträgt z. B. etwa 30 $cm^3$/min bei einer etwa zehnfachen $H_2$-Durchflußrate (alle Durchflußraten Q sind bezogen auf Normalbedingungen = 0 °C und 1000 hPa). Allgemein wird die $WF_6$-Durchflußrate so hoch eingestellt, daß sie bei der jeweiligen Substrattemperatur gerade noch zu einer Abscheidung von Wolfram mit <111>-Textur führt.

Das Dokument EP-A-0 081 270 befaßt sich mit der Herstellung einer thermionischen Kathode. Dabei sind drei Verfahrensschritte zu unterscheiden. In einem ersten Schritt wird Wolfram als Basismaterial abgeschieden, wobei eine Dotierung von 0,5 bis 2 Gew.% strukturstabilisierend wirkt (Anspruch 13 des Dokuments). Es ist hier nicht von einem W <111>-Wachstum, sondern nur von einer Strukturstabilisierung die Rede. Sodann wird eine Emissionsmaterial enthaltende Schicht abgeschieden. Dabei ist die Dotierung verhältnismäßig hoch (Anspruch 14). Schließlich wird eine Deckschicht hergestellt, wobei eine W <111>-Orientierung angestrebt wird, wie es auch bei der vorliegenden Erfindung der Fall ist. Nach Anspruch 23 des Dokuments wird die W <111>-Textur durch Mitabscheiden einer Dotierung von 1 bis 2 % erhalten.

Bei den Untersuchungen, die zur Erfindung geführt haben, wurde jedoch festgestellt, daß bei der bekannten Einstellung der CVD-Parameter nicht immer die gewünschte W<111>-Textur entsteht, sondern in manchen Fällen nur oder auch die bei der $WF_6$-CVD übliche W<100>-Textur. Außerdem muß die $WF_6$-Durchflußrate so niedrig gewählt werden, z. B. kleiner als 5 $cm^3$/min, daß die W-Abscheideraten sehr klein werden und damit die Gesamtverfahrensdauer zu lang wird.

Der Erfindung liegt die Aufgabe zugrunde, ein Verfahren zu schaffen, durch das in reproduzierbarer Weise mit annehmbaren Abscheideraten <111>-vorzugsorientiertes Wolfram hergestellt wird, bei dem also ausschließlich oder fast ausschließlich W<111> abgeschieden und die <100>-Orientierung entweder völlig unterdrückt oder auf weniger als 10 % herabgesetzt wird.

Diese Aufgabe wird erfindungsgemäß dadurch gelöst, daß bei einem Verfahren der eingangs genannten Art ein inertes Trägergas mit einem Seltenerdmetall-Acetylacetonat-Hydrat angereichert wird und zusammen mit den reaktiven Gasen Wolframhexafluorid und Wasserstoff über das Substrat bzw. die aufwachsende Wolframschicht geleitet wird, wobei der Anteil an Seltenerdmetall-Acetylacetonat-Hydrat in der Gasphase 0.05 bis 1 Gew.% beträgt.

Die Ausdrücke « Seltenerdmetall » und « Acetylacetonat » werden im folgenden mit « S.E. » bzw. « AcAc » abgekürzt.

Es ist unerwartet, daß gerade beim erfindungsgemäßen Verfahren eine günstige Beeinflussung des W 111 -Wachstums auftritt. Dabei ist wegen der viel zu niedrigen Dampfdrücke der S.E.-AcAc eine S.E.-Abscheidung nicht nachweisbar (<1 Gew.%).

Als inertes Trägergas kommen z. B. Helium, Argon, Neon, Krypton, Xenon und Stickstoff in Betracht. Vorzugsweise wird Argon verwendet, weil es schon eine relativ große Masse (= Atomgewicht) hat, daher als Trägergas gut geeignet ist, und preiswert erhältlich ist.

Brauchbare S.E.-AcAc-Hydrate sind z. B. solche von La, Ce, Er, Y, Pr, Nd und Gd, die Schmelzpunkte von etwa 150 °C oder darunter aufweisen und in Trihydratform vorliegen. Bevorzugt wird Samarium-Triacetylacetonat-Trihydrat, weil $Sm(AcAc)_3$ eine vergleichsweise hohe thermische Stabilität aufweist, niedrige Verdampfungsraten hat und relativ preiswert ist.

Der Anteil an inertem Trägergas in der Gasphase beträgt vorzugsweise 5 bis 40 Vol.% und richtet sich nach den angestrebten Abscheidebedingungen für die reaktiven Gase. Für die wenig flüchtigen S.E.-AcAc-Hydrate darf der Inertgasdurchsatz nicht zu klein sein, sonst wird zu wenig mitgeführt, andererseits soll Intertgas aber auch nicht in zu großem Maße an der Substratoberfläche adsorbiert werden, sonst treten Wachstumshemmungen auf.

Die Anreicherung des inerten Trägergases mit dem S.E.-AcAc-Hydrat wird vorzugsweise in einem Sättiger vorgenommen, dessen Temperatur 5 bis 10° unter dem Schmelzpunkt des S.E.-AcAc-Hydrats liegt. Ein derartiger Sättiger ist in der DE-A-33 39 625.6 vorgeschlagen worden. Der Sättiger ist mit pulverförmigem S.E.-AcAc-Hydrat gefüllt und wird von dem Trägergas durchströmt.

Als Vorteilhaft hat sich auch gezeigt, daß durch das Erhitzen des S.E.-AcAc-Hydrats eine vorherige Teilentwässerung erreicht wird. Die Teilentwässerung wird zweckmäßigerweise bei Drücken unter 1 hPa

2

und bei Temperaturen zwischen 100 °C und der zuvor erwähnten Sättigertemperatur durchgeführt.

Das erfindungsgemäße Verfahren eignet sich auch zur Herstellung von dotierten Wolframschichten (Simultan-CVD) und von Schichtenfolgen (Alternativ-CVD).

Beim Simultan-CVD-Verfahren wird eine zweite Portion des oder eines anderen inerten Trägergases mit einer reaktiven Verbindung eines Dotierstoffes angereichert und zusammen mit den anderen Gasen über das Substrat bzw. die aufwachsende Wolframschicht geleitet. Die Anreicherung erfolgt dabei zweckmäßigerweise in einem zweiten Sättiger.

Als reaktive Verbindungen von Dotierstoffen werden z. B. metallorganische Verbindungen, insbesondere (wasserfreie) S.E.-metallorganische Verbindungen eingesetzt. Zur Th-Dotierung werden metallorganische Thoriumverbindungen verwendet, vorzugsweise fluorierte $\beta$-Diketonate wie Th-(heptafluordimethyloktandionat)$_4$ oder Th-Trifluoracetylacetonat, weil diese Verbindungen bei ausreichender thermischer Stabilität noch kurz unterhalb des Schmelzpunktes einen genügend hohen Dampfdruck aufweisen. Th-Dotierung ist notwendig für Th-W-Kathodenmaterialien und zur Strukturstabilisierung.

Beim Alternativ-CVD-Verfahren wird die Zufuhr des mit dem Seltenerdmetall-Acetylacetonat-Hydrat angereicherten Trägergases und/oder des mit der reaktiven Verbindung des Dotierstoffes angereicherten Trägergases zeitweilig unterbrochen. In der Praxis werden dazu der oder die Sättiger abwechselnd abgesperrt und dann wieder zugeschaltet. Die derart hergestellten alternierenden Schichten aus hochorientiertem Material haben den Vorteil, daß die Rekristallisation beim Hochtemperatureinsatz stark gehemmt wird.

Vorzugsweise wird die Zufuhr der (des) angereicherten Trägergase(s) solange unterbrochen und fortgesetzt, daß Teilschichten von 0,5 bis 5$\mu$m Dicke entstehen. Derartige Schichten sind insbesondere für Hochtemperaturmaterialien mit geringer Rekristallisationsneigung und gegebenenfalls geeignet orientierter Oberfläche von Bedeutung, die z. B. als Elektrodenmaterialien genügende Form- und Kornstrukturstabilität für ausreichende Lebensdauern aufweisen müssen.

Mit dem zuvor erläuterten Alternativ-CVD-Verfahren lassen sich besonders einfach und vorteilhaft alternierende Schichten aus <111>-W und <100>-W herstellen, wobei ausschließlich WF$_6$ als Wolfram-Ausgangsverbindung eingesetzt werden muß. Dadurch entfallen die Schwierigkeiten, die bisher darauf beruhten, daß zur Herstellung einer anderen Vorzugsorientierung auf Wolframhexachlorid als reaktives Gas umgeschaltet werden mußte, wobei alle Zuführungsleitungen und auch der Reaktor auf 350 °C aufgeheizt werden mußten.

Die Vorteile des erfindungsgemäßen Verfahrens bestehen zusammengefaßt darin, daß die damit erzielten <111>-Wolfram-Schichten sich durch Feinstkristallinität (Korngröße $\leq$ 1 $\mu$m), durch metallischen Glanz und homogenes Wachstum auszeichnen. Ferner können gleichzeitig und/oder alternierend verschiedene Dotierungen bei gleichbleibenden WF$_6$/H$_2$-Abscheideparametern in einem einzigen Beschichtungsprozeß mit abgeschieden werden. Es sind keine reaktorexternen Bearbeitungsschritte notwendig und man kann während des Prozesses bei der WF$_6$-CVD zwischen zwei Orientierungen (<111> und <100>) hin- und herschalten.

Die Erfindung wird nachstehend anhand einiger Ausführungsbeispiele näher erläutert.

Bei allen Beispielen wurden folgende Gas-Durchflußraten angewendet :

Ar : 50 bis 500 cm$^3$/min, vorzugsw. 150 bis 180 cm$^3$/min
N$_2$ : 20 bis 200 cm$^3$/min, vorzugsw. 75 bis 95 cm$^3$/min
WF$_6$ : 5 bis 150 cm$^3$/min, vorzugsw. 10 bis 40 cm$^3$/min
H$_2$ : Das 3- bis 15 fache der WF$_6$-Durchflußrate,

vorzugsweise 60 bis 400 cm$^3$/min.

Der Gesamtdruck lag zwischen 10 und 100 hPa.

Als Substrat wurde Molybdän-Band benutzt, das keiner Oberflächenbehandlung unterzogen wurde. Die reaktive Abscheidung erfolgte bei allen Beispielen in einem CVD-Reaktor aus Edelstahl oder Quarz, in den vakuumdichte Stromdurchführungen zur direkten Substratheizung führten und der einen Gaseinlaß sowie einen Gasauslaß zur Entsorgung gasförmiger Reaktionsprodukte (z. B. HF) aufwies. Der Stickstoff diente als Fensterspülgas, d. h. dazu, das Beobachtungsfenster für die pyrometrische Bestimmung der Substrattemperatur von Belägen aus Reaktionsprodukten freizuhalten und das Beschlagen bei vorgeheiztem Reaktor zu verhindern.

## Beispiel 1

Für eine undotierte W<111>-Abscheidung aus WF$_6$ + H$_2$ vermittels Sm(AcAc)$_3$ · xH$_2$O-angereichertem Ar-Inertgas-Zusatz wurden folgende Verfahrensparameter angewendet :

| Durchflußraten : | Q (WF$_6$) = 5 cm$^3$/min |
| Durchflußraten : | Q (H$_2$) = 60 cm$^3$/min |
| Durchflußraten : | Q (N$_2$) = 90 cm$^3$/min |
| Durchflußraten : | Q (Ar) = 140 cm$^3$/min |

3

0 187 402

Die Sättigertemperatur betrug 135 °C, die Sättigerfüllung bestand aus etwa 5 g Sm(AcAc)$_3$ · xH$_2$O. Die vorherige Sättigerbetriebsdauer war : 3 h bei 135 °C, 4 h bei 100 °C, wodurch eine Teilentwässerung des Sm(AcAc)$_3$-Trihydrats erfolgte. Weitere Parameter waren :

Gesamtdruck p = 36 hPa ;

Substrattemperatur T = 450 bis 500 °C.

Unter diesen Verfahrensbedingungen wurde ein 85- bis 96 %iger Flächenanteil der W<111>-Textur erreicht, was für Kathodenanwendungen ein optimaler Bereich ist. Die nicht direkt angeströmten Rückseiten der Substrate waren unorientiert. Nach noch längerer Entwässerungsdauer bzw. Sättigerbetriebsdauer wurde eine 70 %ige <310>-Textur erhalten.

## Beispiel 2 (Simultan-CVD)

Für Th-dotierte W<111>-Abscheidung wurden folgende Versuchsparameter gewählt : Q(WF$_6$) = 20 cm$^3$/min, Q(H$_2$) = 160 cm$^3$/min, Q(N$_2$) = 90 cm$^3$/min, Q$_{Sätt\ 1}$(Ar) = 140 cm$^3$/min, Q$_{Sätt\ 2}$(Ar) = 100 cm$^3$/min, Gesamtdruck Pges = 30 hPa. Sättiger 1 war wie in Beispiel 1 mit 4 h lang bei 100 °C und 0,3 hPa teilentwässertem Sm(AcAc)$_3$ · xH$_2$O gefüllt ; seine Temperatur betrug 135 °C. Sättiger 2 war mit Th(heptafluordimethyloktandionat)$_4$ gefüllt. Seine Temperatur betrug 140 °C. Durch beide Sättiger strömte Ar als Trägergas mit jeweils gleichen Durchflußraten von 140 cm$^3$/min. Die typische Beschichtungsdauer für eine 10 μm dicke W<111>-Schicht, die etwa 10 Gew.% ThO$_2$ enthielt, betrug etwa 4 h. Die Substrattemperatur lag bei 580 °C. Als Basisschicht wurde vor der Simultan-Beschichtung entweder W 111 -Wolfram, etwa nach Beispiel 1, oder W<100>-Wolfram entsprechend der üblichen WF$_6$ + H$_2$-CVD abgeschieden.

## Beispiel 3 (Alternativ-CVD)

Zunächst wurde W<100> abgeschieden. Sättiger 1 wurde abgetrennt und es floß auch kein Trägergas. Die Abscheidebedingungen waren :

Q(WF$_6$) = 50 cm$^3$/min, Q(H$_2$) = 400 cm$^3$/min, Q(N$_2$) = 70 cm$^3$/min, P$_{ges}$ = 20 hPa, T$_{Substrat}$ = 550 °C ; die Abscheidedauer betrug 5 min.

Danach wurde auf W<111>-Abscheidung umgeschaltet. Dafür wurde Sättiger 1 mit Ar-Trägergasdurchsatz zugeschaltet und es wurden folgende Abscheidebedingungen eingestellt :

Q(WF$_6$) = 20 cm$^3$/min, Q(H$_2$) = 160 cm$^3$/min, Q(N$_2$) = 70 cm$^3$/min, Q$_1$(Ar) = 140 cm$^3$/min, P$_{ges}$ = 30 hPa, T$_{Substrat}$ = 500 °C.

Die Intervalldauer betrug 15 min. Danach wurde die Abfolge von Intervall 1 und Intervall 2 mehrmals wiederholt und man erhielt alternierende W<100>- und W<111>-Schichten von jeweils etwa 5 μm Dicke.

## Patentansprüche

1. Verfahren zur Herstellung von <111>-vorzugsorientiertem Wolfram durch reaktive Abscheidung aus einer Wolframhexafluorid und Wasserstoff enthaltenden Gasphase bei einem Gesamtdruck von 10 bis 100 hPa auf einem Substrat, dadurch gekennzeichnet, daß ein inertes Trägergas mit einem Seltenerdmetall-Acetylacetonat-Hydrat angereichert wird und zusammen mit den reaktiven Gasen Wolframhexafluorid und Wasserstoff über das Substrat bzw. die aufwachsende Wolframschicht geleitet wird, wobei der Anteil an Seltenerdmetall-Acetylacetonat-Hydrat in der Gasphase 0,05 bis 1 Gew.% beträgt.

2. Verfahren nach Anspruch 1, dadurch gekennzeichnet, daß als inertes Trägergas Argon verwendet wird.

3. Verfahren nach Anspruch 1 oder 2, dadurch gekennzeichnet, daß als Seltenerdmetall-Acetylacetonat-Hydrat Samarium-Triacetylacetonat-Trihydrat verwendet wird.

4. Verfahren nach Anspruch 1 oder 2, dadurch gekennzeichnet, daß der Anteil an inertem Trägergas in der Gasphase 5 bis 40 Vol.% beträgt.

5. Verfahren nach Anspruch 1, dadurch gekennzeichnet, daß die Anreicherung des inerten Trägergases mit dem Seltenerdmetall-Acetylacetonat-Hydrat in einem Sättiger vorgenommen wird, dessen Temperatur 5 bis 10 °C unter dem Schmelzpunkt des Seltenerdmetall-Acetylacetonat-Hydrats liegt.

6. Verfahren nach Anspruch 1 oder 5, dadurch gekennzeichnet, daß das Seltenerdmetall-Acetylacetonat-Hydrat zuvor teilentwässert wird.

7. Verfahren nach Anspruch 1, dadurch gekennzeichnet, daß eine zweite Portion des oder eines anderen inerten Trägergases mit einer reaktiven Verbindung eines Dotierstoffes angereichert wird und zusammen mit den anderen Gasen über das Substrat bzw. die aufwachsende Wolframschicht geleitet wird.

8. Verfahren nach Anspruch 7, dadurch gekennzeichnet, daß als reaktive Verbindung des Dotierstoffes eine metallorganische Thoriumverbindung verwendet wird.

9. Verfahren nach Anspruch 1 oder 7, dadurch gekennzeichnet, daß die Zufuhr des mit dem

4

Seltenerdmetall-Acetylacetonat-Hydrat angereicherten Trägergases und/oder des mit der reaktiven Verbindung des Dotierstoffes angereicherten Trägergases zeitweilig unterbrochen wird.

10. Verfahren nach Anspruch 9, dadurch gekennzeichnet, daß die Zufuhr solange unterbrochen und fortgesetzt wird, daß Teilschichten von 0,5 bis 5 μm Dicke entstehen.

**Claims**

1. A method of manufacturing tungsten preferentially orientated in the <111> direction by reactive deposition on a substrate from a gaseous phase containing tungsten hexafluoride and hydrogen at an overall pressure of 10 to 100 hPa, characterized in that an inert carrier gas is enriched with a rare earth metal acetyl acetonate hydrate and is conducted across the substrate and the growing tungsten layer together with the reactive gases tungsten hexafluoride and hydrogen, the share of rare earth metal acetyl acetonate hydrate in the gaseous phase being 0.05 to 1 % by weight.

2. A method as claimed in claim 1, characterized in that argon is used as an inert carrier gas.

3. A method as claimed in claim 1 or 2, characterized in that a samarium triacetyl acetonate trihydrate is used as a rare earth metal acetyl acetonate hydrate.

4. A method as claimed in claim 1 or 2, characterized in that the share of inert carrier gas in the gaseous phase is 5 to 40 vol.%.

5. A method as claimed in claim 1, characterized in that the enrichment of the inert carrier gas with the rare earth metal acetyl acetonate hydrate is effected in a saturator whose temperature is 5 to 10 °C below the melting point of the rare earth metal acetyl acetonate hydrate.

6. A method as claimed in claim 1 or 5, characterized in that the rare earth metal acetyl acetonate hydrate is previously dehydrated partially.

7. A method as claimed in claim 1, characterized in that a second portion of the inert carrier gas or another inert carrier gas is enriched with a reactive compound of a dopant and is conducted accross the substrate and the growing tungsten layer together with the other gases.

8. A method as claimed in claim 7, characterized in that a metalorganic thorium compound is used as a reactive compound of the dopant.

9. A method as claimed in claim 1 or 7, characterized in that the supply of the carrier gas enriched with the rare earth metal acetyl acetonate hydrate and/or of the carrier gas enriched with the reactive compound of the dopant is temporarily interrupted.

10. A method as claimed in claim 9, characterized in that the supply is interrupted and continued for such a long period that partial layers of 0.5 to 5 μm thickness are obtained.

**Revendications**

1. Procédé pour la préparation de tungstène à orientation préférentielle <111> par dépôt réactif d'une phase gazeuse contenant un hexafluorure de tungstène et de l'hydrogène sous une pression totale de 10 à 100 hPa sur un substrat, caractérisé en ce qu'un gaz véhicule inerte est enrichi d'un acétylacétonate hydraté de métal des terres rares et l'on fait passer, ensemble avec les gaz réactifs hexafluorure de tungstène et hydrogène sur le substrat respectivement la couche de tungstène en croissance, la part d'acétylacétonate hydraté de métal des terres rares dans la phase gazeuse étant de 0,05 à 1 % en poids.

2. Procédé selon la revendication 1, caractérisé en ce que de l'argon est utilisé comme gaz véhicule inerte.

3. Procédé selon la revendication 1 ou 2, caractérisé en ce que comme acétylacétonate-hydraté de métal des terres rares, on utilise du trihydrate de triacétylacétonate de samarium.

4. Procédé selon la revendication 1 ou 2, caractérisé en ce que la part de gaz véhicule inerte dans la phase gazeuse est de 5 à 40 % en volume.

5. Procédé selon la revendication 1, caractérisé en ce que l'enrichissement du gaz véhicule inerte à l'aide d'acétylacétonate hydraté de métal des terres rares est effectué dans un saturateur dont la température est inférieure de 5 à 10° au point de fusion d'acétylacétonate hydraté de métal des terres rares.

6. Procédé selon la revendication 1 ou 5, caractérisé en ce que l'acétylacétonate hydraté de métal des terres rares est préalablement partiellement déshydraté.

7. Procédé selon la revendication 1, caractérisé en ce qu'une deuxième portion du gaz véhicule inerte ou d'un autre gaz véhicule inerte est enrichie d'un composé réactif d'un dopant et passe, ensemble avec l'autre gaz, sur le substrat respectivement la couche de tungstène en croissance.

8. Procédé selon la revendication 7, caractérisé en ce que comme composé réactif du dopant, on utilise un composé de thorium organométallique.

9. Procédé selon la revendication 1 ou 7, caractérisé en ce que l'amenée du gaz véhicule enrichi de l'acétylacétonate-hydraté de métal des terres rares et/ou du gaz véhicule enrichi du composé réactif du dopant est temporairement interrompue.

10. Procédé selon la revendication 9, caractérisé en ce que l'amenée est interrompue et poursuivie de façon qu'il se forme des couches partielles d'une épaisseur de 0,5 à 5 μm.